# EUROPEAN PATENT APPLICATION

(11) **EP 4 708 353 A1**
(43) Date of publication of application: **11.03.2026**
(21) Application number: 24848052.7
(22) Date of filing: 19.07.2024

(54) **IGBT DEVICE AND CELLULAR STRUCTURE THEREOF, AND MANUFACTURING METHOD FOR CELLULAR STRUCTURE**

(30) Priority: 28.07.2023 CN 202310945231
(71) Applicant: Gree Electric Appliances, Inc. of Zhuhai, Zhuhai, Guangdong 519070 (CN)
(72) Inventor: ZHANG, Fusheng, Zhuhai, Guangdong 519070 (CN); XIE, Zixiang, Zhuhai, Guangdong 519070 (CN); LI, Chunyan, Zhuhai, Guangdong 519070 (CN); LIAO, Yongbo, Zhuhai, Guangdong 519070 (CN)
(74) Representative: Zacco GmbH
(86) International application number: PCT/CN2024/106507
(87) International publication number: WO 2025/026093

(57) **Abstract**

Provided are an IGBT device and a cell structure thereof, and a manufacturing method for the cell structure. The method includes: forming a first-type drift region; forming a first-type doped pillar region and a second-type doped pillar region on a first surface of the first-type drift region; forming a base region, an emitter region and a polysilicon gate on the first-type doped pillar region and the second-type doped pillar region; forming a heavily doped buffer region and a lightly doped buffer region on a second surface of the first-type drift region opposite to the first surface, wherein the heavily doped buffer region and the lightly doped buffer region are arranged in the same layer; and fabricating a collector region on a side of the heavily doped buffer region and the lightly doped buffer region opposite to the first-type drift region. A buffer layer is formed into a heavily doped buffer region and a lightly doped buffer region with different doping concentrations, wherein the heavily doped buffer region can suppress the electric field, ensuring that the voltage withstand capability of an IGBT device is not affected; and the lightly doped buffer region can effectively improve the carrier recombination rate, thereby increasing the current density, and effectively optimizing the switching and conduction characteristics of the device.

## Description

The present disclosure claims priority to the Chinese patent application, filed with the China National Intellectual Property Administration on July 28, 2023, with application number 2023109452319, and entitled "IGBT Device and Cell Structure thereof, and Manufacturing Method for Cell Structure", which is incorporated herein by reference in its entirety.

### Technical Field

The present invention relates to the technical field of insulated gate bipolar transistors, and in particular, to an IGBT device and a cell structure thereof, and a manufacturing method for the cell structure.

### Background

Insulated gate bipolar transistors have been widely used in the field of power devices due to their high power capability, and have continued to advance with technological progress. IGBT (Insulated Gate Bipolar Transistor) is expanding toward applications with higher power levels. In recent years, the performance improvements of IGBT have mainly relied on the following technologies: (1) trench technology, (2) punch-through IGBT, (3) injection enhancement technology, and (4) minority carrier lifetime control technology. However, these technologies provide only limited improvements to the device or represent trade-off approaches that address one aspect at the expense of another.

The invention of the super junction technology has overcome the so-called "silicon limit," fundamentally resolving the contradiction between increasing breakdown voltage and reducing on-resistance in traditional power devices. The device cell size can be made smaller, with lower on-state voltage drop and turn-off loss, making it an efficient and environmentally friendly new type of power semiconductor with broad application prospects in medium and high-voltage fields. Compared with traditional IGBT structures, a super junction structure (SJ), composed of N- and P-type pillars of certain widths stacked side by side in the epitaxial layer, can optimize the electric field distribution in the drift region of the device, enhancing the breakdown voltage capability of the device. As long as the doping concentration of the PIN-pillars is appropriate and satisfies the charge balance condition, when the withstand voltage is passed, the PN junction in the drift region assists in depletion during voltage withstand, so that the breakdown voltage of the device no longer depends on the doping concentration of the drift region, but solely related to the thickness of the device. Under balanced pillar conditions, the device is likely to achieve its maximum breakdown voltage. Under the premise of maintaining the voltage withstand capability, the doping concentration of the drift region can be significantly improved, thereby reducing the on-resistance of the device.

To further improve the conduction and switching performance of the device, it often requires a significant increase in cost. Therefore, how to optimize the structure of the super junction IGBT to improve its conduction and switching performance and reduce power consumption without significantly increasing the cost is an urgent issue that needs to be addressed at present.

### Summary

Based on this, it is necessary to provide an IGBT device and a cell structure thereof, and a manufacturing method for the cell structure to address the described technical problems.

A manufacturing method for a cell structure of an IGBT includes:
a first-type drift region is formed;
a first-type doped pillar region and a second-type doped pillar region are formed on a first surface of the first-type drift region;
a base region, an emitter region and a polysilicon gate are formed on a side of the first-type doped pillar region and the second-type doped pillar region opposite to the first-type drift region;
a heavily doped buffer region and a lightly doped buffer region are formed on a second surface of the first-type drift region opposite to the first surface, wherein a doping concentration of the heavily doped buffer region is greater than a doping concentration of the lightly doped buffer region, and the heavily doped buffer region and the lightly doped buffer region are disposed in a same layer; and
a collector region is formed on a side of the heavily doped buffer region and the lightly doped buffer region opposite to the first-type drift region.

In some embodiments, the lightly doped buffer region is at least partially aligned with the second-type doped pillar region in a direction perpendicular to the first surface of the first-type drift region.

In some embodiments, a width ratio of the heavily doped buffer region to the lightly doped buffer region is (5-11):1.

In some embodiments, a doping concentration ratio of the heavily doped buffer region to the lightly doped buffer region is (50-200):1.

In some embodiments, a step of forming a heavily doped buffer region and a lightly doped buffer region on a second surface of the first-type drift region opposite to the first surface incldues:
a buffer region is formed on the second surface of the first-type drift region;
the buffer region is lightly doped to form a doped buffer region; and
secondary doping is performed on a first portion of the doped buffer region to form the heavily doped buffer region in the first portion, while secondary doping is not performed on a second portion of the doped buffer region to form the lightly doped buffer region in the second portion.

A cell structure of an IGBT includes:
a first-type drift region;
a first-type doped pillar region and a second-type doped pillar region formed on a first surface of the first-type drift region;
a base region, an emitter region and a polysilicon gate formed on the first-type doped pillar region and the second-type doped pillar region;
a heavily doped buffer region and a lightly doped buffer region formed on a second surface of the first-type drift region, wherein the second surface of the first-type drift region is disposed opposite to the first surface, a doping concentration of the heavily doped buffer region is greater than a doping concentration of the lightly doped buffer region, and the heavily doped buffer region and the lightly doped buffer region are disposed in a same layer; and
a collector region disposed on a side of the heavily doped buffer region and the lightly doped buffer region opposite to the first-type drift region.

In some embodiments, the lightly doped buffer region is at least partially aligned with the second-type doped pillar region in a direction perpendicular to the first surface of the first-type drift region.

In some embodiments, a width ratio of the heavily doped buffer region to the lightly doped buffer region is (5-11):1.

In some embodiments, a doping concentration ratio of the heavily doped buffer region to the lightly doped buffer region is (50-200):1.

An IGBT device includes the cell structure in any one of the described embodiments.

According to the described the IGBT device and the cell structure thereof, and the manufacturing method for the cell structure, the buffer layer is formed into a heavily doped buffer region and a lightly doped buffer region with different doping concentrations. The heavily doped buffer region can suppress the electric field, ensuring that the voltage withstand capability of the IGBT device is not affected; and the lightly doped buffer region can effectively improve the carrier recombination rate, thereby increasing the current density, and effectively optimizing the switching and conduction characteristics of the device. The structure of the super junction IGBT is optimized without incurring additional cost or without a significant increase in cost, effectively improving the conduction and switching performance of the device.

### Brief Description of the Drawings

Fig. 1 is a schematic flow diagram of a manufacturing method for a cell structure of an IGBT according to an embodiment of the present invention;
Fig. 2 is a schematic structural diagram of a cell structure of an IGBT according to an embodiment of the present invention;
Fig. 3 is a schematic diagram comparing the carrier recombination rate along the y-axis in one embodiment with that of a traditional IGBT device;
Fig. 4 is a schematic diagram comparing the relationship curve between Eoff and Von in one embodiment with the relationship curve between Eoff and Von of a traditional IGBT device.

### Detailed Description of the Embodiments

To make the objectives, technical solutions and advantages of the present invention more apparent, the present invention will be further described in detail below with reference to the accompanying drawings and embodiments. It should be understood that the specific embodiments described herein are merely illustrative of the invention and are not intended to limit the invention.

It should be noted that when an element is referred to as being "fixed to" or "provided on" another element, the element may be directly on the other element or there may be an intermediate element. When an element is referred to as being "connected" to another element, it may be directly connected to the other element or there may be an intermediate element. The terms "vertical," "horizontal," "left," "right," and similar expressions as used herein are for illustrative purposes only and do not indicate that they are the only embodiments.

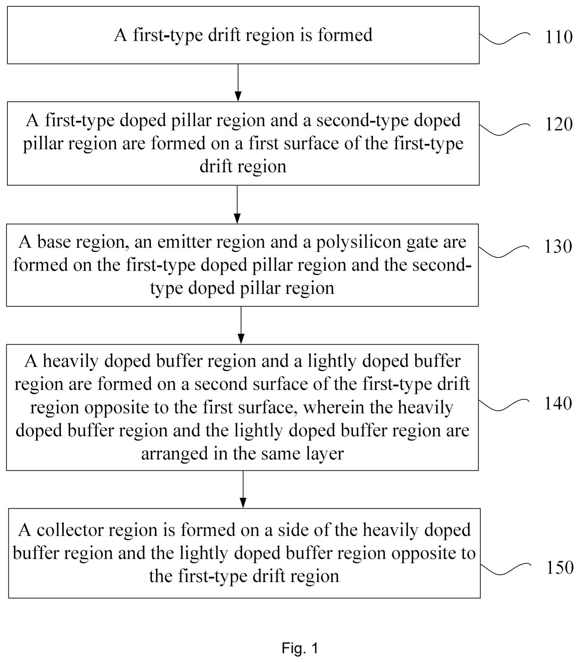

In some embodiments, as shown in Fig. 1, a manufacturing method for a cell structure of an IGBT is provided, including:
step 110, a first-type drift region is formed.

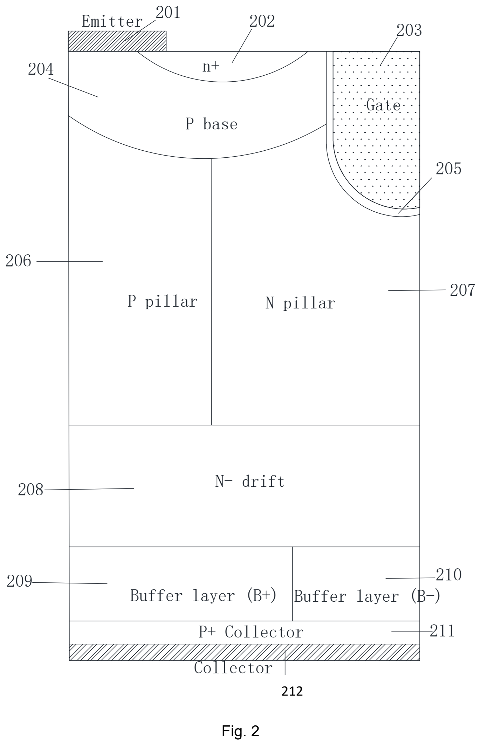

In these embodiments, as shown in Fig. 2, the first-type drift region 208 is an N-type drift region. The process of forming the first-type drift region 208 includes performing epitaxial growth on a substrate to form a first epitaxial layer, and then performing N-type doping on the first epitaxial layer to obtain the first-type drift region 208.

In some embodiments, epitaxial growth is performed on the substrate to form a first epitaxial layer, and N-type doping is performed on the first epitaxial layer to obtain the first-type drift region 208.

Step 120, a first-type doped pillar region and a second-type doped pillar region are formed on a first surface of the first-type drift region.

In these embodiments, as shown in Fig. 2, the first-type doped pillar region 206 and the second-type doped pillar region 207 are also referred to as a first-type doped pillar and a second-type doped pillar. In these embodiments, the first-type doped pillar region 206 is a P-type doped pillar region, and the second-type doped pillar region 207 is an N-type doped pillar region. Therefore, the first-type doped pillar region 206 and the second-type doped pillar region 207 may also be referred to as a P-pillar and an N-pillar.

In some embodiments, a mask is used to etch a trench of a preset width and a preset depth on the first surface of the first-type drift region 208. The trench is filled with single-crystal silicon, which then undergoes P-type doping at a preset concentration and a thermal drive-in process, thereby forming alternating first-type doped pillar region 206 and second-type doped pillar region 207.

Step 130, a base region, an emitter region and a polysilicon gate are formed on the first-type doped pillar region and the second-type doped pillar region, that is, a base region, an emitter region and a polysilicon gate are formed on a side of the first-type doped pillar region opposite to the first-type drift region and on a side of the second-type doped pillar region opposite to the first-type drift region.

In these embodiments, as shown in Fig. 2, the base region 204 is a P-type base region 204 (P base region). In some embodiments, an epitaxy is performed on a first-type doped pillar region 206 and a second-type doped pillar region 207 to obtain a second epitaxial layer, and a P-type doping is performed on the second epitaxial layer to obtain a P-type base region 204. N-type doping is performed on a surface of the P-type base region 204 along the lateral direction of the device to form an N+ emitter region 202, wherein the lateral direction of the device refers to the direction parallel to the surface of the P-type base region 204. A trench region is formed adjacent to the N+ emitter region 202, penetrating through the P-type base region 204, with the bottom of the trench region in contact with the first-type doped pillar region 206 and the second-type doped pillar region 207. The trench region includes an insulating dielectric layer 205 located on the side wall of the trench region and a polysilicon conductive material surrounded by the insulating dielectric layer 205, wherein the insulating dielectric layer 205 is made of SiO₂, and the insulating dielectric layer 205 is also referred to as a gate oxide layer. A gate electrode is led out from the polysilicon conductive material in the trench region, forming a trench gate structure, i.e. a polysilicon gate electrode 203. The contact portion between the N+ emitter region 202 and the P-type base region 204 leads out an emitter electrode, forming an emitter region 201.

Step 140, a heavily doped buffer region and a lightly doped buffer region are formed on a second surface of the first-type drift region opposite to the first surface, wherein the heavily doped buffer region and the lightly doped buffer region are arranged in the same layer, and the doping concentration of the heavily doped buffer region is greater than the doping concentration of the lightly doped buffer region.

In these embodiments, a buffer layer is formed on the second surface of the first-type drift region 208 opposite to the first surface. The buffer layer differs from the prior art in that the buffer layer includes a heavily doped buffer region 209 and a lightly doped buffer region 210 that are adjacent and connected to each other. The doping concentration of the heavily doped buffer region 209 is greater than the doping concentration of the lightly doped buffer region 210. In some embodiments, the heavily doped buffer region 209 is a heavily doped N+ buffer region, and the lightly doped buffer region 210 is a lightly doped N+ buffer region.

For ease of description, in the embodiments, the first surface of the first-type drift region 208 is defined as the front surface of the first-type drift region 208, and the second surface of the first-type drift region 208 is defined as the back surface of the first-type drift region 208. In these embodiments, a heavily doped buffer region 209 and a lightly doped buffer region 210 are formed in the same layer on the back surface of the first-type drift region 208. The high-concentration heavily doped buffer region 209 can suppress the electric field, ensuring that the voltage withstand capability of the IGBT device is not affected. The low-concentration lightly doped buffer region 210 can effectively improve the carrier recombination rate, thereby increasing the current density and effectively optimizing the switching and conduction characteristics of the device.

In some embodiments, the heavily doped buffer region 209 is at least partially aligned with the first-type doped pillar region 206 in a direction perpendicular to the first surface of the first-type drift region 208, and the lightly doped buffer region 210 is at least partially aligned with the second-type doped pillar region 207 in a direction perpendicular to the first surface of the first-type drift region 208.

In some embodiments, the heavily doped buffer region 209 is at least partially aligned with the first-type doped pillar region 206 in a direction perpendicular to the front surface of the first-type drift region 208, and the lightly doped buffer region 210 is at least partially aligned with the second-type doped pillar region 207 in a direction perpendicular to the front surface of the first-type drift region 208. As shown in Fig. 2, the heavily doped buffer region 209 is located on the same side as the first-type doped pillar region 206, and the lightly doped buffer region 210 is located on the same side as the second-type doped pillar region 207. In this way, as the heavily doped buffer region 209 is close to the P-pillar, and the lightly doped buffer region 210 is close to the N-pillar, when electrons flow from the N-pillar toward the buffer layer, the proximity of the lightly doped buffer region 210 to the N-pillar is more conducive to enhancing the current density.

In some embodiments, the step of forming a heavily doped buffer region 209 and a lightly doped buffer region 210 on a second surface of the first-type drift region 208 opposite to the first surface includes: a buffer region is formed on the second surface of the first-type drift region 208; lightly doping is performed on the buffer region to form a doped buffer region; secondary doping is performed on a first portion of the doped buffer region to form the heavily doped buffer region 209 in the first portion; and no secondary doping is performed on a second portion of the doped buffer region to form the lightly doped buffer region 210 in the second portion.

In these embodiments, a buffer region is formed on the back surface of the first-type drift region 208.The buffer region is first lightly doped, i.e., subjected to a first N-ion implantation to obtain a doped buffer region. Then, a mask is used to cover a portion of the region, and a second N-ion implantation (secondary doping) is performed. The masked region, which does not undergo the second N-ion implantation, becomes the lightly doped buffer region 210, while the unmasked region becomes the heavily doped buffer region 209. As a result, the heavily doped buffer region 209 with an electric field suppression function and the lightly doped buffer region 210 with enhanced current density are obtained.

In some embodiments, the doping concentration ratio of the heavily doped buffer region 209 to the lightly doped buffer region 210 is (50-200):1.

In this way, the high-concentration heavily doped buffer region 209 effectively suppresses the electric field, ensuring that the voltage withstand capability of the IGBT device is not affected. The low-concentration lightly doped buffer region 210 can effectively improve the carrier recombination rate, thereby improving the current density, and effectively optimizing the switching and conduction characteristics of the device.

In some embodiments, the doping concentration ratio of the heavily doped buffer region 209 to the lightly doped buffer region 210 is 100:1. The doping concentration of the heavily doped buffer region 209 is 2×10¹⁶ cm⁻³, and the doping concentration of the lightly doped buffer region 210 is 2×10¹⁴ cm⁻³, with a doping concentration ratio of 100:1. The doping material is phosphorus.

In these embodiments, the lightly doped buffer region 210, which undergoes only the initial light doping without secondary doping, has a doping concentration of 2×10¹⁴ cm⁻³, while the heavily doped buffer region 209, which undergoes both light doping and secondary doping, has a doping concentration of 2×10¹⁶ cm⁻³. The doping concentration ratio of the heavily doped buffer region 209 to the lightly doped buffer region 210 is 100:1. In this way, the heavily doped buffer region 209 more effectively suppresses the electric field, while the lightly doped buffer region 210 further improves the carrier recombination rate, thereby enhancing the current density and effectively optimizing the switching and conduction characteristics of the device.

Step 150, a collector region is formed on a side of the heavily doped buffer region and the lightly doped buffer region opposite to the first-type drift region.

In these embodiments, as shown in Fig. 2, P-type heavy doping is performed on the buffer layer to obtain a collector region, and a metal layer is deposited on the collector region and led out as a collector terminal, thereby forming a collector region 211. In these embodiments, the collector region 211 is a P-type heavily doped collector region 211.

In these embodiments, the P-pillar, utilizing the charge balance theory, can assist in depleting the N-type drift region, resulting in a nearly constant longitudinal electric field in the N-type drift region. This increases the effective voltage withstand area of the drift region, thereby enhancing the breakdown voltage of the device. Additionally, holes in the P-pillar of the N-type drift region can compensate for the excess electron current flowing from the source electrode. With an increased doping concentration in the N-type drift region, the on-resistance of the device is reduced, and the turn-on loss is also reduced. The buffer layer is divided into two regions with different doping concentrations. The high-concentration heavily doped buffer region 209 can restrict the diffusion of the electric field, while the low-concentration lightly doped buffer region 210 enhances the carrier recombination rate, thereby increasing current density. This reduces the on-state voltage drop and turn-off loss, enabling lower power consumption of the entire super junction IGBT without compromising the device's voltage withstand capability, thus improving the overall performance of the chip.

In some embodiments, the width ratio of the first-type doped pillar region 206 to the second-type doped pillar region 207 is 1:(1-3). In these embodiments, the width ratio of the P-pillar to the N-pillar is 1:1 to 1:3. As the N-pillar has a larger width, it facilitates an increase in the current density flowing through the N-pillar, thereby further enhancing the conduction performance of the IGBT device.

In some embodiments, the ratio width of the first-type doped pillar region 206 to the second-type doped pillar region 207 is 1:2. It should be understood that if the width ratio of the P-pillar to the N-pillar is too small, it would result in the P-pillar being too narrow to effectively restrict the diffusion of the electric field. In these embodiments, the width ratio of the P-pillar to the N-pillar is 1:2, which can ensure that the P-pillar has sufficient width to effectively compensate for the excess electron current flowing from the source electrode. Additionally, as the width of the N-pillar is greater than the width of the P-pillar and is twice the width of the P-pillar, it can effectively increase the current density flowing through the N-pillar, thereby reducing the on-state voltage drop and turn-off loss, and further enhancing the conduction performance of the IGBT device.

In some embodiments, the doping concentration ratio of the first-type doped pillar region 206 to the second-type doped pillar region 207 is 2:1. In these embodiments, the doping concentration of the P-pillar is higher than the doping concentration of the N-pillar, such that the P-pillar can effectively restrict the diffusion of the electric field, while the N-pillar can better support the passage of current, increasing the current density flowing through the N-pillar.

To achieve a balance between voltage withstand capability and on-resistance, In some embodiments, the width ratio of the heavily doped buffer region 209 to the lightly doped buffer region 210 is (5-11): 1. In these embodiments, the width ratio of the heavily doped buffer region 209 to the lightly doped buffer region 210 is 5:1 to 11:1. This allows the heavily doped buffer region 209 to more effectively suppress the electric field, ensuring that the voltage withstand capability of the device is not affected. Meanwhile, the narrower lightly doped buffer region 210 can improve the carrier recombination rate, increase current density, and enhance the switching and conduction characteristics of the device. The width ratio of 5:1 to 11:1 between the heavily doped buffer region 209 and the lightly doped buffer region 210 effectively achieves a balance between voltage withstand capability and on-resistance.

In some embodiments, the width ratio of the heavily doped buffer region 209 to the lightly doped buffer region 210 is 9:1. In these embodiments, the heavily doped buffer region 209 is designed to more effectively suppress the electric field, ensuring better voltage withstand characteristics of the device; and the lightly doped buffer region 210 can more effectively improve the carrier recombination rate, increase the current density, and enhance the switching and conduction characteristics of device. Therefore, the width ratio of the heavily doped buffer region 209 to the lightly doped buffer region 210 is 9:1, which can more effectively achieve a balance between voltage withstand capability and on-resistance.

In some embodiments, as shown in Fig. 2, a cell structure of an IGBT is provided, including: a first-type drift region 208, a first-type doped pillar region 206, a second-type doped pillar region 207, a heavily-doped buffer region 209, a lightly-doped buffer region 210, a base region 204, an emitter region 201, a polysilicon gate electrode 203 and a collector region 211. The first-type doped pillar region 206 and the second-type doped pillar region 207 are formed on a first surface of the first-type drift region 208; the base region 204, the emitter region 201 and the polysilicon gate electrode 203 are formed on the first-type doped pillar region 206 and the second-type doped pillar region 207; the heavily doped buffer region 209 and the lightly doped buffer region 210 are formed on a second surface of the first-type drift region 208, wherein the second surface of the first-type drift region 208 is disposed opposite to the first surface; and the collector region 211 is formed on a side of the heavily doped buffer region 209 and the lightly doped buffer region 210 opposite to the first-type drift region 208.

In these embodiments, the first-type drift region 208 is an N-type drift region, the first-type doped pillar region 206 is a P-pillar super junction region, the second-type doped pillar region 207 is an N-pillar super junction region, the heavily doped buffer region 209 is a heavily doped N+ buffer region, the lightly doped buffer region 210 is a lightly doped N+ buffer region, the base region 204 is a P-type base region 204, and the emitter region is an N+ emitter region 202. In some embodiments, the P-type base region 204 is formed on the first-type doped pillar region 206 and the second-type doped pillar region 207, and the N+ emitter region 202 is formed on the P-type base region 204. The N+ emitter region 202 forms a trench region that penetrates through the P-type base region 204, with the bottom of the trench region connected to the N-pillar super junction region. The side wall of the trench region is provided with an insulating dielectric layer 205, a polysilicon conductive material is disposed on the inner side of the insulating dielectric layer 205, and the insulating dielectric layer 205 covers the outer side of the polysilicon conductive material. An emitter electrode is connected to the junction between the P-type base region 204 and the N+ emitter region 202, and the emitter electrode is connected to both the P-type base region 204 and the N+ emitter region 202. The polysilicon conductive material is connected to a gate electrode, thereby forming a polysilicon gate electrode 203.

In these embodiments, the P-pillar, utilizing the charge balance theory, can assist in depleting the N-type drift region, resulting in a nearly constant longitudinal electric field in the N-type drift region. This increases the effective voltage withstand area of the drift region, thereby enhancing the breakdown voltage of the device. Additionally, holes in the P-pillar of the N-type drift region can compensate for the excess electron current flowing from the source electrode. With an increased doping concentration in the N-type drift region, the on-resistance of the device is reduced, and the turn-on loss is also reduced. The buffer layer is divided into two regions with different doping concentrations. The high-concentration heavily doped buffer region 209 can restrict the diffusion of the electric field, while the low-concentration lightly doped buffer region 210 enhances the carrier recombination rate, thereby increasing current density. This reduces the on-state voltage drop and turn-off loss, enabling lower power consumption of the entire super junction IGBT without compromising the device's voltage withstand capability, thus improving the overall performance of the chip.

In some embodiments, the heavily doped buffer region 209 and the lightly doped buffer region 210 are arranged in the same layer. The heavily doped buffer region 209 is at least partially aligned with the first-type doped pillar region 206 in a direction perpendicular to the first surface of the first-type drift region 208, and the lightly doped buffer region 210 is at least partially aligned with the second-type doped pillar region 207 in a direction perpendicular to the first surface of the first-type drift region 208.

The heavily doped buffer region 209 is at least partially aligned with the first-type doped pillar region 206 in a direction perpendicular to the front surface of the first-type drift region 208, and the lightly doped buffer region 210 is at least partially aligned with the second-type doped pillar region 207 in a direction perpendicular to the front surface of the first-type drift region 208. As shown in Fig. 2, the heavily doped buffer region 209 is located on the same side as the first-type doped pillar region 206, and the lightly doped buffer region 210 is located on the same side as the second-type doped pillar region 207. In this way, as the heavily doped buffer region 209 is close to the P-pillar, and the lightly doped buffer region 210 is close to the N-pillar, when electrons flow from the N-pillar toward the buffer layer, the proximity of the lightly doped buffer region 210 to the N-pillar is more conducive to enhancing the current density.

In some embodiments, the heavily doped buffer region 209 is at least partially offset from the second-type doped pillar region 207 in a direction perpendicular to the first surface of the first-type drift region 208. In some embodiments, the lightly doped buffer region 210 is completely offset from the first-type doped pillar region 206 in a direction perpendicular to the first surface of the first-type drift region 208. In these embodiments, the heavily doped buffer region 209 is partially offset from the N-pillar, that is, the heavily doped buffer region 209 is not aligned with the N-pillar, while the lightly doped buffer region 210 is completely offset from the P-pillar. In this way, the heavily doped buffer region 209 is located closer to the P-pillar, and the lightly doped buffer region 210 is located closer to the N-pillar. When electrons flow from the N-pillar toward the buffer layer, the proximity of the lightly doped buffer region 210 to the N-pillar is more conducive to enhancing the current density.

To achieve a balance between voltage withstand capability and on-resistance, In some embodiments, the width ratio of the heavily doped buffer region 209 to the lightly doped buffer region 210 is (5-11): 1. In these embodiments, the width ratio of the heavily doped buffer region 209 to the lightly doped buffer region 210 is 5:1 to 11:1. This allows the heavily doped buffer region 209 to more effectively suppress the electric field, ensuring that the voltage withstand capability of the device is not affected. Meanwhile, the narrower lightly doped buffer region 210 can improve the carrier recombination rate, increase current density, and enhance the switching and conduction characteristics of the device. The width ratio of 5:1 to 11:1 between the heavily doped buffer region 209 and the lightly doped buffer region 210 effectively achieves a balance between voltage withstand capability and on-resistance.

In some embodiments, the width ratio of the heavily doped buffer region 209 to the lightly doped buffer region 210 is 9:1. In these embodiments, the heavily doped buffer region 209 is designed to more effectively suppress the electric field, ensuring better voltage withstand characteristics of the device; and the lightly doped buffer region 210 can more effectively improve the carrier recombination rate, increase the current density, and enhance the switching and conduction characteristics of device. Therefore, the width ratio of the heavily doped buffer region 209 to the lightly doped buffer region 210 is 9:1, which can more effectively achieve a balance between voltage withstand capability and on-resistance.

In some embodiments, the doping concentration ratio of the heavily doped buffer region 209 to the lightly doped buffer region 210 is (50-200):1.

In this way, the high-concentration heavily doped buffer region 209 effectively suppresses the electric field, ensuring that the voltage withstand capability of the IGBT device is not affected. The low-concentration lightly doped buffer region 210 can effectively improve the carrier recombination rate, thereby improving the current density, and effectively optimizing the switching and conduction characteristics of the device.

In some embodiments, the doping concentration ratio of the heavily doped buffer region 209 to the lightly doped buffer region 210 is 100:1. The doping concentration of the heavily doped buffer region 209 is 2×10¹⁶ cm⁻³, and the doping concentration of the lightly doped buffer region 210 is 2×10¹⁴ cm⁻³, with a doping concentration ratio of 100:1. The doping material is phosphorus.

In these embodiments, the lightly doped buffer region 210, which undergoes only the initial light doping without secondary doping, has a doping concentration of 2×10¹⁴ cm⁻³, while the heavily doped buffer region 209, which undergoes both light doping and secondary doping, has a doping concentration of 2×10¹⁶ cm⁻³. The doping concentration ratio of the heavily doped buffer region 209 to the lightly doped buffer region 210 is 100:1. In this way, the heavily doped buffer region 209 more effectively suppresses the electric field, while the lightly doped buffer region 210 further improves the carrier recombination rate, thereby enhancing the current density and effectively optimizing the switching and conduction characteristics of the device.

In some embodiments, as shown in Fig. 2, a cell structure of an IGBT is provided. The parts in Fig. 2 are illustrated as follows: 201 is an emitter region;202 is a heavily doped N region; 203 is a polysilicon gate electrode; 204 is a P-type base region; 205 is an SiO2 gate oxide layer; 206 is a P-type doped pillar region;207 is an N-type doped pillar region; 208 is an N-type drift region; 209 is a heavily doped buffer region; 210 is a lightly doped buffer region; 211 is a P-type heavily doped collector region; and 212 is a back metal region.

It should be noted that, the names of parts may be the same as or different from those in the foregoing embodiments, and parts with the same reference signs should be understood as different names of the same parts.

In these embodiments, the P-pillar, utilizing the charge balance theory, can assist in depleting the N-type drift region, resulting in a nearly constant longitudinal electric field in the N-type drift region. This increases the effective voltage withstand area of the drift region, thereby enhancing the breakdown voltage of the device. Additionally, holes in the P-pillar of the N-type drift region can compensate for the excess electron current flowing from the source electrode. With an increased doping concentration in the N-type drift region, the on-resistance of the device is reduced, and the turn-on loss is also reduced. The buffer layer is divided into two regions with different doping concentrations. The high-concentration heavily doped buffer region can restrict the diffusion of the electric field, while the low-concentration lightly doped buffer region enhances the carrier recombination rate, thereby increasing current density. This reduces the on-state voltage drop and turn-off loss, enabling lower power consumption of the entire super junction IGBT without compromising the device's voltage withstand capability, thus improving the overall performance of the chip.

In these embodiments, a manufacturing method for a cell structure of an IGBT is provided: a corresponding cell structure is formed on the surface of an N-drift high-resistivity semiconductor substrate. First, epitaxial growth is performed on the substrate to obtain a first doped layer.

Subsequently, the epitaxial layer is subjected to N-type doping, and a mask is then used to etch a trench of a preset width and a preset depth on the first surface of the first-type drift region 208. The trench is filled with single-crystal silicon, which then undergoes P-type doping at a preset concentration and a thermal drive-in process, thereby forming an alternating P-pillar and N-pillar super junction region.

Subsequently, epitaxial growth is performed on the P-pillar and N-pillar super junction region. The P-type base region is formed by P-type doping of the epitaxial layer. N-type doping is performed on the surface of the P-type base region along the lateral direction of the device to form an N+ emitter region. A trench region is formed adjacent to the N+ emitter region 202, penetrating through the P-type base region 204, with the bottom of the trench region in contact with P-pillar and N-pillar super junction regions. The trench region consists of a SiO₂ insulating dielectric layer on the inner wall of the trench and a polysilicon conductive material surrounded by the insulating dielectric layer. A gate electrode is led out from the conductive material in the trench region, forming a trench gate structure.

The common lead-out terminal of the N+ emitter region and the P+ body contact region is an emitter electrode.

On the back surface of the N- drift high-resistivity semiconductor region, a photolithography process is used to perform alternating high-concentration and low-concentration N-type doping along the lateral direction of the device, obtaining a heavily doped N+ buffer layer with an electric field suppression function and a lightly doped N- buffer layer with enhanced current density. The specific process is as follows: first, the buffer layer is lightly doped; then, using a photolithography process, a portion of the region is masked, followed by a second N-ion implantation. The masked region becomes the lightly doped region, while the unmasked region becomes the heavily doped region.

P-type heavy doping is performed on the buffer layer to form a collector region, and a thin metal layer is deposited on the collector region to lead out as a collector terminal.

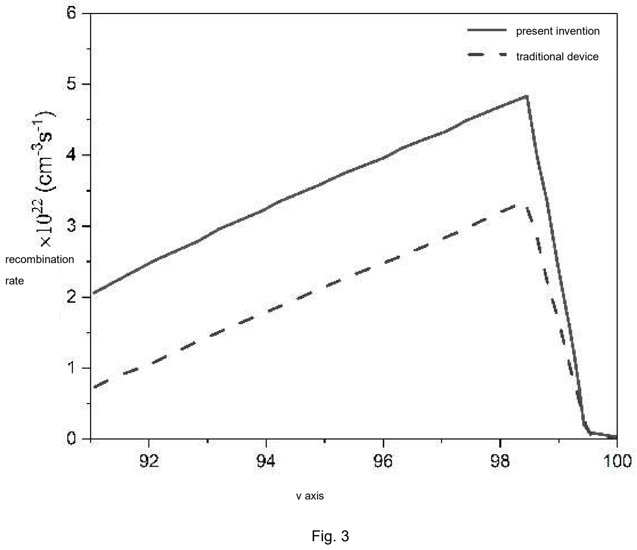

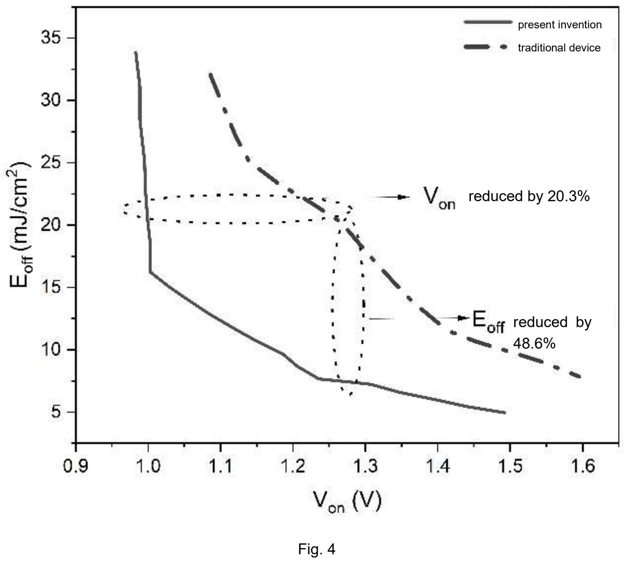

Figs. 3 and 4 are device simulation waveform diagrams. In some embodiments, Fig. 3 is the carrier recombination rate near the longitudinal buffer layer of the device structure. The solid line represents the structure of the present invention, while the dashed line represents a traditional device structure. It can be determined that, under the same conditions, the carrier recombination rate in the buffer layer of the present invention's structure is significantly higher than that of the traditional structure. Fig. 4 is a graph illustrating the trade-off relationship between the on-state voltage (Von) and the turn-off loss (Eoff) during the device simulation process. The solid line represents the structure disclosed in the present invention, while the dotted line represents a traditional structure. It can be determined that, under the same turn-off loss, the Von of the structure disclosed in the present invention is reduced by 20.3% compared to the traditional structure; and under the same on-state voltage, the Eoff of the present invention is reduced by 48.8% compared to the traditional structure. The overall switching performance and power consumption are both improved.

In some embodiments, an IGBT device is provided, including the cell structure in any one of the described embodiments.

The technical features of the foregoing embodiments may be combined in any way; and for brevity of description, not all possible combinations of the technical features in the foregoing embodiments are described. However, as long as combinations of these technical features do not conflict with each other, all these technical features should be considered to fall within the scope of the description.

The foregoing embodiments merely represent several implementations of the present invention, with more specific and detailed descriptions. However, they should not be construed as limiting the scope of the invention patent It should be noted that, for those skilled in the art, various modifications and improvements can be made without departing from the concept of the present invention, and all these modifications and improvements belong to the scope of protection of the present invention. Therefore, the scope of protection of the present invention should be subject to the appended claims.

## Claims

1. A manufacturing method for a cell structure of an IGBT, comprising:
forming a first-type drift region;
forming a first-type doped pillar region and a second-type doped pillar region on a first surface of the first-type drift region;
forming a base region, an emitter region and a polysilicon gate on a side of the first-type doped pillar region opposite to the first-type drift region and a side of the second-type doped pillar region opposite to the first-type drift region;
forming a heavily doped buffer region and a lightly doped buffer region on a second surface of the first-type drift region opposite to the first surface, wherein a doping concentration of the heavily doped buffer region is greater than a doping concentration of the lightly doped buffer region, and the heavily doped buffer region and the lightly doped buffer region are disposed in a same layer; and
forming a collector region on a side of the heavily doped buffer region and the lightly doped buffer region opposite to the first-type drift region.

2. The manufacturing method for a cell structure of an IGBT according to claim 1, wherein the lightly doped buffer region is at least partially aligned with the second-type doped pillar region in a direction perpendicular to the first surface of the first-type drift region.

3. The manufacturing method for a cell structure of an IGBT according to claim 1, wherein a width ratio of the heavily doped buffer region to the lightly doped buffer region is (5-11):1.

4. The manufacturing method for a cell structure of an IGBT according to claim 1, wherein a doping concentration ratio of the heavily doped buffer region to the lightly doped buffer region is (50-200):1.

5. The method for manufacturing a cell structure of an IGBT according to any one of claims 1-4, wherein a step of forming a heavily doped buffer region and a lightly doped buffer region on a second surface of the first-type drift region opposite to the first surface comprises:
forming a buffer region on the second surface of the first-type drift region ;
lightly doping the buffer region to form a doped buffer region; and
performing secondary doping on a first portion of the doped buffer region to form the heavily doped buffer region in the first portion, while not performing secondary doping on a second portion of the doped buffer region to form the lightly doped buffer region in the second portion.

6. A cell structure of an IGBT, comprising:
a first-type drift region;
a first-type doped pillar region and a second-type doped pillar region disposed on a first surface of the first-type drift region;
a base region, an emitter region and a polysilicon gate disposed on the first-type doped pillar region and the second-type doped pillar region;
a heavily doped buffer region and a lightly doped buffer region disposed on a second surface of the first-type drift region, wherein the second surface of the first drift region is disposed opposite to the first surface, a doping concentration of the heavily doped buffer region is greater than a doping concentration of the lightly doped buffer region, and the heavily doped buffer region and the lightly doped buffer region are disposed in a same layer; and
a collector region disposed on a side of the heavily doped buffer region and the lightly doped buffer region opposite to the first-type drift region.

7. The cell structure of an IGBT according to claim 6, wherein the lightly doped buffer region is at least partly aligned with the second-type doped pillar region in a direction perpendicular to the first surface of the first-type drift region.

8. The cell structure of an IGBT according to according to claim 6 or 7, wherein a width ratio of the heavily doped buffer region to the lightly doped buffer region is (5-11):1.

9. The cell structure of an IGBT according to claim 6 or 7, wherein a doping concentration ratio of the heavily doped buffer region to the lightly doped buffer region is (50-20):1.

10. An IGBT device, comprising the cell structure of any one of claims 6-9.
